# EUROPÄISCHE PATENTSCHRIFT

(11) **EP 0 590 180 B1**
(45) Veröffentlichungstag und Bekanntmachung des Hinweises auf die Patenterteilung: **10.01.1996**
(21) Anmeldenummer: 92116651.8
(22) Anmeldetag: 29.09.1992
(51) Int. Cl.: B60R 21/00

(54) **Messanordnung zur Prüfung der Masseanschlüsse einer Schaltung, z.B. Steuerschaltung eines Airbagsystemes eines Kfz**
Measure device for testing the earth connections of a control circuit, for example control circuit of an airbag system of a vehicle
Dispositif de mesure pour tester les connexions de masse d'une commande, par exemple commande d'un système d'airbag d'un véhicule

(43) Veröffentlichungstag der Anmeldung: 06.04.1994
(73) Patentinhaber: SIEMENS AKTIENGESELLSCHAFT, D-80333 München (DE)
(72) Erfinder: Swart, Martin, Dipl.-Ing., W-8407 Obertraubling (DE)

(56) Entgegenhaltungen:
- DE-A- 4 032 423
- US-A- 4 366 465
- ELECTRONIC ENGINEERING Bd. 54, Nr. 662, 1982, LONDON - GB Seite 29 TOVARA 'EARTH LINE FAILURE DETECTOR CIRCUIT'

## Beschreibung

Die Erfindung betrifft eine Meßanordnung zur Prüfung der Masseanschlüsse einer Schaltung, z.B. einer Steuerschaltung eines Airbagsystems eines Kraftfahrzeugs, nach dem Oberbegriff des Patentanspruches 1.

Die Erhöhung der Zuverlässigkeit der Erdung einer Schaltung ist von Bedeutung, um große Gefahren, z.B. für das Leben von Personen, abzuwenden. Die Erfindung wurde zwar zunächst für die Erdung der Steuerschaltung eines Airbagsystemes eines Kfz entwickelt. Es zeigte sich aber schnell, daß sie auch für die Erdung anderer sicherheitsrelevanter Steuerschaltungen von Kfz-Insassenschutzsystemen geeignet ist, darüber hinaus sogar für die Erdung beliebiger anderer Schaltungen, bei denen die Erhöhung ihrer Zuverlässigkeit einen Zusatzaufwand rechtfertigt, z.B. bei Alarmanlagen.

Aus der Druckschrift DE 40 32 423 A1 ist eine Schaltung mit einer Anzeigeeinrichtung bekannt, bei der ein zu erdender Schaltungspunkt mit zwei parallelen Erdleitungen mit Masse verbunden wird, um die Zuverlässigkeit der Erdung der Schaltung zu erhöhen. Über einen Widerstand, der mit einer der Erdleitungen und mit einer Steuereinrichtung verbunden ist, wird mit einer Spannungsprüfung der Masseanschluß dieser Erdleitung überprüft.

Die Aufgabe,
- die Zuverlässigkeit der Erdung einer Schaltung zu erhöhen, indem - bereits gravierende, oder sogar schon sich erst anbahnende - Defekte der Erdung der Schaltung selbsttätig erkannt werden,
- wobei die Meßwiderstände gleichzeitig als Schutz gegen eine irrtümlich falsche Polung der von außen angelegten Betriebsspannung dienen können, wird erfindungsgemäß durch den im Patentanspruch 1 definierten Gegenstand gelöst. Die Erfindung gestattet also, erheblich Gefahren für die Erdung der Schaltung zu vermindern, Gefahren, die im Prinzip schon bei einer neuen Schaltung, aber vor allem durch die Alterung der Schaltung entstehen können.

Die in den Unteransprüchen definierten Gegenstände gestatten, zusätzliche Vorteile zu erreichen. U.a. gestatten nämlich die zusätzlichen Maßnahmen gemäß dem Patentanspruch
2, elektromagnetische, kapazitive und induktive Einkopplungen von Störungen zumindest weitgehend zu unterdrücken, wobei Kreisströme in dem evtl. vorhandenen Stromkreis - der durch die Leitungen L1/L2 und einer direkten leitenden Verbindung über den dortigen Abschnitt des Gehäuses G gebildet sein kann - zusätzlich durch die Dioden G1/G2 unterdrückt werden, die in diesem Stromkreis gegensinnig gepolt angeordnet sind,
3, die Schaltung einschließlich ihrer Erdleitungen weitgehend gegen elektromagnetische, kapazitive und induktive Einkopplungen von Störungen zu schützen, selbst falls die Erdleitungen nicht längs ihrer gesamten Länge dicht beieinander liegen sollten,
4, den Aufwand an Energie für die Prüfung zu reduzieren,
5, durch die Prüfung zuverlässig den Betrieb der Schaltung nicht zu stören, - auch wenn dieser Betrieb der Schaltung einer jahrelang dauernden pausenartigen Betriebsbereitschaft entspricht, in der die Schaltung mangels entsprechender Eingangssignale kein Ausgangssignal abgibt,
6, die Strompfade, über welche die an den Meßwiderständen auftretenden Spannungen geprüft werden, untereinander weitgehend zu entkoppeln,
7, auch außerhalb der Schaltung in der Verbindung zur Masse ohnehin vorhandene Widerstände als Meßwiderstände benutzen zu können, und
8, mit wenig Aufwand die gesamte Schaltung durch eine einzige erfindungsgemäße Maßnahme zuverlässig zu erden.

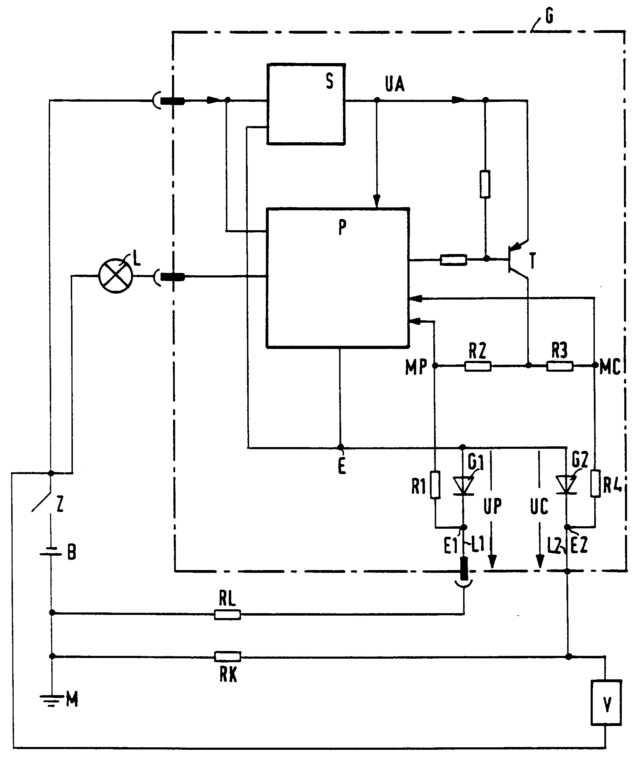

Die Erfindung und Weiterbildungen derselben werden anhand des in der Figur gezeigten Ausführungsbeispieles der Erfindung weiter erläutert, welche der Übersichtlichkeit wegen möglichst einfach dargestellt wurde.

Die Figur zeigt also ein Beispiel der erfindungsgemäßen Schaltung S, P, die eine Meßanordnung T, R1 bis R4, L1, L2, G1, G2, enthält. Die Schaltung besteht z.B. aus zwei Einheiten, nämlich der Steuereinheit P sowie dem Netzteil S, das eine stabilisierte Betriebsspannung UA besonders für die Steuereinheit P - sowie stabilisierte Vorspannungen für den Prüftransistor T - erzeugt. Die Schaltung einschließlich ihrer Meßanordnung wird über den Schalter Z - z.B. über das Zündschloß eines Kfz - an ihre Versorgungsspannung gelegt, vgl. die Batterie B.

Die Meßanordnung dient zur Prüfung der Masseanschlüsse E1, E2 der Schaltung S, P. Diese Schaltung soll während der gesamten Dauer des bestimmungsgemäßen Gebrauchs dieser Schaltung hochzuverlässig geerdet sein. Die Schaltung stellt z. B. eine Steuerschaltung eines Airbagsystemes eines Kfz dar, die während ihrer gesamten bestimmungsgemäßen Betriebsdauer hochzuverlässig sein muß. Dazu soll sich die Schaltung mit Hilfe ihrer Meßanordnung selbst laufend von Zeit zu Zeit prüfen und sogar dann bereits Alarm auslösen, wenn sie erkennt, daß die Erdung derzeit zwar noch immer funktioniert, daß aber die Erdung trotzdem bereits erste Mängel aufweist, also die Erdung der Schaltung sofort repariert oder die ganze Schaltung ausgetauscht werden sollte.

Die - z.B. in einem metallischen Abschirmgehäuse G angebrachte - Schaltung besitzt, um die Zuverlässigkeit der Erdung der Schaltung zu erhöhen, erfindungsgemäß ZWEI Masseanschlüsse E1, E2, die über ZWEI getrennte Erdleitungen L1, L2 niederohmig Massepotential an den Schaltungspunkt E heranführen sollen. Die Schaltung besitzt nämlich einen zu erdenden Schaltungspunkt E mit erfindungsgemäß zwei, unter sich parallel geschalteten Erdleitungen L1, L2, die den Schaltungspunkt E mit der Masse M verbinden. In jeder der beiden Erdleitungen L1, L2 ist jeweils ein eigener Meßwiderstand eingefügt, vgl. G1 und G2. Die Erfindung besitzt demnach ZWEI Erdungen, obwohl die Fachwelt, wie oben beschrieben, stets eine "Sternerdung" anstrebt, also die Erdung über nur EINEN Masseanschluß.

In jeder der beiden Erdleitungen L1, L2 ist der Meßwiderstand, vgl. G1 und G2, jeweils durch eine Diode gebildet. Die Meßwiderstände - insbesondere die Dioden G1, G2, die für die zur Masse M fließenden, normalen Betriebsströme in Durchlaßrichtung gepolt sind - sind alle jeweils so niederohmig, daß diese normalen Betriebsströme der Schaltung S, P keinen zu hohen Spannungsabfall UP bzw. UC an ihnen erzeugen; der Schaltungspunkt E soll ja jedenfalls nahezu auf Massepotential liegen.

Weil die Meßwiderstände G1 und G2 jeweils in - für die normalen Betriebsströme - Durchlaßrichtung gepolte Dioden sind, können diese Meßwiderstände G1, G2 gleichzeitig als Schutz gegen eine irrtümlich falsche Polung der von außen angelegten Betriebsspannung, vgl. die Batterie B, dienen. Darüber hinaus wird aber durch die so geschalteten Dioden D1 und D2 erreicht, daß Ströme, die von der Batterie B über den - beliebigen, außerhalb der Schaltung angeschlossenen - Verbraucher V fließen, nicht in zwei Komponenten aufspalten, nämlich
- in eine erste Komponente, die über den - z.B. durch einen Karosserieabschnitt gebildeten - Widerstand RK fließt könnte, und
- in eine zweite Komponente, die über die zweite Erdleitung L2, den Schaltungspunkt E, die erste Erdleitung L1 und den - z.B. durch einen Leiter eines Kabelbaumes gebildeten - Widerstand RL fließen könnte, wobei diese zweite Komponente das Potential des Schaltungspunktes E anheben könnte.

Wegen der Diode G2, die für die zweite Komponente in Sperrrichtung gepolt ist, kann keine solche zweite Komponente fließen, weswegen auch das Potential am Schaltungspunkt E nicht mehr durch eine solche zweite Komponente gestört werden kann. Das Potential am Schaltungspunkt wird immer von jener der beiden Dioden G1/G2 festgelegt, welche am Masseanschluß E1 bzw. E2 ein Potential aufweist, das dem Potential der Masse M am nächsten kommt.

Die Meßanordnung prüft zumindest gelegentlich die Intaktheit der Masseanschlüsse E1, E2 beider Erdleitungen L1, L2 mittels der Spannungen UP, UC. Diese Spannungen kann die Meßanordnung während des Betriebes der Schaltung selber zu Prüfzwecken vorübergehend an den Meßwiderständen G1, G2, RL, RK erzeugen oder, falls diese Spannungen ohnehin während des Betriebes vorhanden sind, einzeln für sich beobachten. Die Meßanordnung soll schon bei einer Fehlerhaftigkeit von einer der beiden Erdungen L1/E1 oder L2/E2 Alarm auslösen, nämlich z.B. einen Summton oder z.B. die Warnleuchte L einschalten, und / oder gleichsam als Alarm irgendeinen Sicherheitsschalter irgendeiner anderen Schaltungsanordnung betätigen - je nach dem Zweck, zu dem die erfindungsgemäße Schaltung jeweils verwendet wird.

Das Gehäuse G ist hier bevorzugterweise metallisch leitend und dient gleichzeitig zur Abschirmung der Schaltung vor elektromagnetischen, kapazitiven und / oder induktiven Störungen. Weil beide, hier am Gehäuse G - wenn auch voneinander isoliert - angebrachten Masseanschlüsse E1, E2 praktisch keinen Eigenwiderstand aufweisen, solange sie intakt sind, erzeugen die Betriebsströme der Schaltung S, P - auch evtl. die zu Prüfzwecken in die Erdleitungen L1, L2 eingespeisten, Prüfströme darstellenden Stromimpulse - keine deutlichen Unterschiede der Spannungen UP und UC. Wenn aber einer der beiden Masseanschlüsse E1, E2 mehr oder weniger defekt wird, dann steigt sein Eigenwiderstand, der dann evtl. sogar unendlich groß wird. Dann unterscheiden sich die Spannungen UP und UC signifikant, so daß - hier die Steuereinheit P, welche hier nämlich auch die Größe der Spannungen UP und UC überwacht - den Alarm auslösen kann. Die Meßanordnung - in Verbindung mit der Doppelerdung L1/E1, L2/E2 - löst dann also schon bei der Fehlerhaftigkeit von einer der beiden Erdungen L1/E1 oder L2/E2 den Alarm aus. Die andere dieser zwei Erdungen funktioniert dann aber noch einwandfrei, so daß bei einem Unfall weiterhin zuverlässig der Airbag ausgelöst wird. Der Fahrzeugbenutzer wird aber durch die Erfindung rechtzeitig gewarnt, die Schaltung - genauer eigentlich: deren Erdung - reparieren zu lassen oder die ganze Schaltung austauschen zu lassen, bevor auch die andere Erdung defekt wird. Die Erfindung vermindert also erheblich die Gefahren, die vor allem durch die Alterung der Schaltung entstehen können, z.B. verursacht durch die Vibrationen im Kfz.

Um die bei doppelter Erdung gefürchteten elektromagnetischen, kapazitiven und induktiven Einkopplungen von Störungen zumindest weitgehend zu unterdrücken, können die Masseanschlüsse E1, E2 im Gehäuse G nahe beieinander angebracht werden. Außerdem können zum selben Zweck die Erdleitungen L1, L2 untereinander jeweils räumlich dicht beieinander angebracht werden, also z.B. sogar miteinander mehr oder weniger verdrillt werden. Zusätzlich kann man zu denselben Zwecken die ganze Schaltung einschließlich ihrer Meßanordnung, zumindest aber ihre Erdleitungen L1, L2 und Masseanschlüsse E1, E2 in einem geerdeten leitenden Abschirmgehäuse G anbringen. Mittels eines solchen Abschirmgehäuses G kann man sogar einen gewissen Schutz gegen elektromagnetische, kapazitive und induktive Einkopplungen von Störungen auch dann erreichen, wenn die Erdleitungen L1, L2 nicht längs ihrer gesamten Länge dicht beieinander liegen sollten - jedenfalls wenn die Störungen von außen, z.B. von der Zündung des Kfz-Motors kommen. Soweit solche Störungen von Teilen der Schaltung S, P selbst stammen, erreicht man durch die Abschirmung bzw. Kapselung der Erdleitungen L1, L2 einschließlich ihrer Masseanschlüsse E1, E2 ebenfalls einen entsprechenden Schutz.

Um den Aufwand an Energie für die Prüfung zu reduzieren, kann die Meßanordnung einen Prüftransistor T enthalten, der zum Überprüfen der Masseanschlüsse E1, E2 von Zeit zu Zeit Stromimpulse über die Erdleitungen L1, L2 abgibt. Weil im gezeigten Beispiel dieser Stromimpuls - beispielhaft - unmittelbar bei den Masseanschlüssen E1, E2 in die Erdleitungen L1, L2 eingespeist wird, erzeugen diese Stromimpulse starke Unterschiede zwischen den Spannungen UP und UC, woran die Steuereinheit P den Defekt von einem der beiden Masseanschlüsse E1, E2 sofort entdeckt.

Steuerschaltungen für Airbags und andere Insassenschutzsysteme müssen zwar während der Fahrt des Kfz ständig eingeschaltet sein; sie sollen aber erst bei einem Unfall ein besonderes Ausgangssignal abgeben, das die Insassenschutzanordnung auslöst. Ähnlich verhält es sich mit Alarmanlagen. Um durch die Prüfung zuverlässig den Betrieb der Schaltung nicht zu stören - auch wenn dieser Betrieb der Schaltung einer jahrelang dauernden pausenartigen Betriebsbereitschaft entspricht, in der die Schaltung mangels entsprechender Eingangssignale kein Ausgangssignal abgibt - , kann der Prüftransistor T seine Stromimpulse, an der eigentlichen Schaltung S, P vorbei, unmittelbar in die Erdleitungen L1, L2 einspeisen. Günstig ist dann oft z.B. - um die Strompfade, über welche die an den Meßwiderständen, vgl. G1 und G2, auftretenden Spannungen, vgl. UP und UC, geprüft werden, untereinander weitgehend zu entkoppeln, den Prüftransistor T so anzuordnen, daß er seine Stromimpulse jeweils über ein Widerstandsnetzwerk R2/R1, R3/R4 in die Erdleitungen L1, L2 einspeist, wobei dann die Spannungen MP, MC, die im Netzwerk R2/R1, R3/R4 auftreten, als Indikatoren für die Spannungen UP, UC an den Meßwiderständen G1, G2, RL, RK benutzt werden können.

Der Prüftransistor T kann übrigens seine Stromimpulse gleichzeitig in die beiden Erdleitungen L1, L2 einspeisen. Er kann aber seine Stromimpulse auch taktversetzt einspeisen, nämlich zuerst in die erste Erdleitung L1, später in die andere Erdleitung L2. Beide Verfahren sind weitgehend gleichwertig, wenn die Absolutwerte beider Spannungen UP und UC, bzw. MP und MC, gemessen - und evtl. in der Steuereinheit P gespeichert - werden. Wenn hingegen nur die Differenz zwischen diesen Spannungen UP-UC bzw. MP-MC gemessen wird, ist es einfacher, die Stromimpulse gleichzeitig in die beiden Erdleitungen L1, L2 einzuspeisen.

Um auch außerhalb der Schaltung in der Verbindung zur Masse ohnehin vorhandene Widerstände RL, RK als Meßwiderstände benutzen zu können, können - besonders wenn die Schaltung S, P als Steuerschaltung eines Kfz-Insassenschutzsystemes, z.B. Airbagsystemes und / oder Überrollbügelsystemes, dient - die Masseanschlüsse E1, E2 über getrennte Strompfade RL, RK mit der Masse M verbunden werden, wobei zumindest einer dieser Meßwiderstände RL, RK z.B. wie schon erwähnt durch den Eigenwiderstand eines Karosserieabschnittes RK und/oder einer Kabelbaumleitung RL gebildet werden kann. Wie die Figur beispielhaft zeigt, können bei der Erfindung die Masseanschlüsse, vgl. E2, außerhalb der Schaltung, bzw. außerhalb des Gehäuses G, einen gemeinsamen Strompfad mit sonstigen Verbrauchern V zur Masse M aufweisen. Einzelne der Meßwiderstände - besonders die Dioden G1, G2, die gegen eine fehlerhafte Batteriepolung und gegen eine Aufspaltung der Ströme durch den Verbraucher V und damit gegen Störungen des Potentials des Schaltungspunktes E schützen - können trotzdem im Inneren des Gehäuses G angebracht werden, wobei im gezeigten Beispiel die Stromimpulse des Prüftransistors T dann in einen Abgriff E1 bzw. E2 der Serienschaltungen G1/RL und G2/RK eingespeist werden können.

Um mit wenig Aufwand die gesamte Schaltung durch eine einzige erfindungsgemäße Maßnahme zuverlässig zu erden, kann der Schaltungspunkt E zentral die ganze Schaltung S, P erden. Im Prinzip kann aber die Schaltung auch mehrere, voneinander getrennte Schaltungspunkte E enthalten, an die möglichst niederohmig das Massepotential heranzuführen ist.

Dann können alle diese verschiedenen Schaltungspunkte E, jeder für sich, erfindungsgemäß mit zwei Erdleitungen, vgl. L1 und L2, ausgestattet werden, die alle für sich erfindungsgemäß geprüft werden, um eine hochzuverlässige Erdung aller dieser Schaltungspunkte E zu erreichen.

## Patentansprüche

1. Schaltung (S, P) mit Meßanordnung zur Prüfung ihrer Masseanschlüsse (E1, E2) während der gesamten Dauer des bestimmungsgemäßen Gebrauchs dieser Schaltung (S, P), z.B. zur Prüfung der Masseanschlüsse der Steuerschaltung eines Airbagsystemes eines Kraftfahrzeugs, wobei ein zu erdender Schaltungspunkt (E) der Schaltung (S, P) mit zwei parallelen Erdleitungen (L1, L2) mit Masse (M) verbunden ist,
**dadurch gekennzeichnet,**
- daß jede Erdleitung mindestens einen eigenen Meßwiderstand (G1, G2, RL, RK) enthält, wobei mindestens ein Meßwiderstand je Erdleitung (L1, L2) durch eine Diode gebildet wird,
- daß die Meßwiderstände (G1, G2, RL, RK) für die normalen, zur Masse (M) fließenden Betriebsströme der Schaltung (S, P) niederohmig sind, und
- daß eine Prüfeinrichtung vorgesehen ist, durch die die Spannungen (UP, UC) an den Meßwiderständen (G1, G2, RL, RK) überprüft werden und eine fehlerhafte Erdung signalisiert wird.

2. Schaltung (S, P) nach Patentanspruch 1,
**dadurch gekennzeichnet,**
- daß sowohl die Masseanschlüsse (E1, E2) untereinander als auch die Erdleitungen (L1, L2) untereinander jeweils räumlich dicht beieinander liegen.

3. Schaltung (S, P) nach Patentanspruch 1 oder 2,
**dadurch gekennzeichnet,**
- daß die Erdleitungen (L1, L2) zwischen der Schaltung (S, P) und einem geerdeten leitenden Abschirmgehäuse (G) angeschlossen sind.

4. Schaltung (S, P) nach einem der vorhergehenden Patentansprüche,
**dadurch gekennzeichnet,**
- daß sie einen Prüftransistor (T) enthält, der zum Überprüfen der Masseanschlüsse (E1, E2) von Zeit zu Zeit Stromimpulse über die Erdleitungen (L1, L2) abgibt.

5. Schaltung (S, P) nach Patentanspruch 4,
**dadurch gekennzeichnet,**
- daß der Prüftransistor (T) seine Stromimpulse, an der eigentlichen Schaltung (S, P) vorbei, unmittelbar in die Erdleitungen (L1, L2) einspeist.

6. Schaltung (S, P) nach Patentanspruch 5,
**dadurch gekennzeichnet,**
- daß der Prüftransistor (T) seine Stromimpulse jeweils über ein Widerstandsnetzwerk (R2/R1, R3/R4) in die Erdleitungen (L1, L2) einspeist, und
- daß Spannungen (bei MP, MC), die im Netzwerk (R2/R1, R3/R4) auftreten, als Indikatoren für die Spannungen (UP, UC) an den Meßwiderständen (G1, G2, RL, RK) benutzt werden.

7. Schaltung (S, P) nach einem der vorhergehenden Patentansprüche, die als Steuerschaltung (S, P) eines Kfz-Insassenschutzsystemes, z.B. Airbagsystemes und / oder
Überrollbügelsystemes, dient,
**dadurch gekennzeichnet,**
- daß die Masseanschlüsse (E1, E2) über getrennte Strompfade (RL, RK) mit der Masse (M) verbunden werden, und
- daß zumindest einer der Meßwiderstände (G1, G2, RL, RK) durch den Eigenwiderstand eines Karosserieabschnittes (RK) und / oder einer Kabelbaumleitung (RL) gebildet wird.

8. Schaltung (S, P) nach einem der vorhergehenden Patentansprüche,
**dadurch gekennzeichnet,**
- daß der Schaltungspunkt (E) zentral die ganze Schaltung (S, P) erdet.

## Claims

1. Circuit (S, P) with measuring arrangement for testing its earth terminals (E1, E2) during the entire duration of the correct use of this circuit (S, P), for example for testing the earth terminals of the control circuit of an airbag system of a motor vehicle, a switching point (E), to be earthed, of the circuit (S, P) being connected to earth (M) with two parallel earthing lines (L1, L2), characterized
- in that each earthing line contains at least one separate measuring resistor (G1, G2, RL, RK), at least one measuring resistor being formed per earthing line (L1, L2) by means of a diode,
- in that the measuring resistors (G1, G2, RL, RK) for the normal operating currents, flowing to earth (M), of the circuit (S, P) have low impedance, and
- in that a test device is provided by means of which the voltages (UP, UC) at the measuring resistors (G1, G2, RL, RK) are checked and incorrect earthing is signalled.

2. Circuit (S, P) according to Patent Claim 1, characterized
- in that both the earth terminals (E1, E2) are connected to one another and the earthing lines (L1, L2) are connected to one another, in each case lying spatially right next to one another.

3. Circuit (S, P) according to Patent Claim 1 or 2, characterized,
- in that the earthing lines (L1, L2) are connected between the circuit (S, P) and an earthed conductive screened housing (G).

4. Circuit (S, P) according to one of the preceding patent claims, characterized
- in that it contains a testing transistor (T) which from time to time outputs current pulses via the earthing lines (L1, L2) in order to check the earth terminals (E1, E2).

5. Circuit (S, P) according to Patent Claim 4, characterized
- in that the testing transistor (T) feeds its current pulses past the actual circuit (S, P) and directly into the earthing lines (L1, L2).

6. Circuit (S, P) according to Patent Claim 5, characterized
- in that the testing transistor (T) feeds its current pulses into the earthing lines (L1, L2) in each case via a resistor network (R2/R1, R3/R4), and
- in that voltages (at MP, MC) which occur in the network (R2/R1, R3/R4) are used as indicators for the voltages (UP, UC) at the measuring resistors (G1, G2, RL, RK).

7. Circuit (S, P) according to one of the preceding patent claims, which serves as a control circuit (S, P) of a system for protecting the occupants of motor vehicles, for example an airbag system and/or roll bar system, characterized
- in that the earth terminals (E1, E2) are connected to earth (M) via separate current paths (RL, RK) and
- in that at least one of the measuring resistors (G1, G2, RL, RK) is formed by the intrinsic resistance of a section (RK) of the vehicle body and/or of a cable harness line (RL).

8. Circuit (S, P) according to one of the preceding patent claims, characterized
- in that the switching point (E) earths the entire circuit (S, P) centrally.

## Revendications

1. Circuit (S, P) comprenant un dispositif de mesure pour tester ses raccordements à la masse (E1, E2) pendant la totalité de la durée d'utilisation prévue de ce circuit (S, P), par exemple pour tester les raccordements à la masse du circuit de commande d'un système de coussin gonflable d'un véhicule automobile, un point de commutation (E) destiné à être mis à la terre, du circuit (S, P) étant relié par deux conducteurs de terre (L1, L2) à la masse (M),
caractérisé en ce que
- chaque ligne de terre comporte au moins sa propre résistance de mesure (G1, G2, RL, RK), au moins une résistance de mesure de chaque conducteur de terre (L1, L2) étant constituée par une diode,
- les résistances de mesure (G1, G2, RL, RK) destinées au courants de fonctionnement normaux, allant à la masse (M) du circuit (S, P), sont faiblement ohmiques, et
- un dispositif de test est prévu, au moyen duquel les tensions (UP, UC) sur les résistances de mesure (G1, G2, RL, RK) sont contrôlées et tout défaut de la mise à la masse faisant l'objet d'une signalisation.

2. Circuit (S, P) selon la revendication 1, caractérisé en ce que
- tant les raccordements de masse (E1, E2) entre eux qu'également les lignes de terre (L1, L2) entre elles sont respectivement placées près les uns des autres.

3. Circuit (S, P) selon la revendication 1 ou 2, caractérisé en ce que,
les lignes de terre (L1, L2) sont raccordées entre le circuit (S, P) et un boîtier de blindage (G), conducteur, mis à la terre.

4. Circuit (S, P) selon l'une quelconque des revendications précédentes,
caractérisé en ce qu'
- il comporte un transistor de contrôle (T), envoyant de temps en temps des impulsions électriques dans les lignes de terre (L1, L2), en vue de tester les raccordements de masse (E1, E2).

5. Circuit (S, P) selon la revendication 4, caractérisé en ce que
- le transistor de contrôle (T) envoie ses impulsions électriques directement dans les lignes de terre (L1, L2) en dérivation sur le circuit (S, P) proprement dit.

6. Circuit (S, P) selon la revendication 5, caractérisé en ce que
- le transistor de contrôle (T) envoie ses impulsions électriques dans les lignes de terre (L1, L2) par un réseau de résistances (R2/R1, R3/R4), et
- les tensions présentes (en MP, MC) dans le réseau ( R2/R1, R3/R4) sont utilisées comme indicateurs des tensions (UP, UC) sur les résistances de mesure (G1, G2, RL, RK).

7. Circuit (S, P) selon l'une quelconque des revendications précédentes, servant de circuit de commande (S, P) d'un système de protection des passagers d'un véhicule automobile, par exemple d'un système à coussin gonflable et/ou d'un système d'arceau de sécurité, caractérisé en ce que
- les raccordements de masse (E1, E2) sont reliés à la masse (M) par des chemins électriques (RL, RK) séparés, et
- au moins l'une des résistances de mesure (G1, G2, RL, RK) est constitué par la résistance propre d'une section de carrosserie (RK) et/ou un conducteur d'un faisceau de fils (RL).

8. Circuit (S, P) selon l'une quelconque des revendications précédentes,
caractérisé en ce que
- le point de branchement (E) assure la mise à la terre centrale de tout le circuit (S, P).
